# FASCICULE DE BREVET EUROPEEN

(11) **EP 3 590 129 B1**
(45) Date de publication et mention de la délivrance du brevet: **04.11.2020**
(21) Numéro de dépôt: 18709702.7
(22) Date de dépôt: 26.02.2018
(51) Int. Cl.: H01L 21/02, H01L 33/00, H01L 21/762

(54) **PROCEDE DE FABRICATION D'UN SUBSTRAT DONNEUR POUR LA FORMATION DE DISPOSITIFS OPTOELECTRONIQUES**
VERFAHREN ZUR HERSTELLUNG EINES DONORSUBSTRATS ZUR HERSTELLUNG OPTOELEKTRONISCHER VORRICHTUNGEN
METHOD FOR MANUFACTURING A DONOR SUBSTRATE FOR MAKING OPTOELECTRONIC DEVICES

(30) Priorité: 01.03.2017 FR 1751666
(43) Date de publication de la demande: 08.01.2020
(73) Titulaire: Soitec, 38190 Bernin (FR)
(72) Inventeur: SOTTA, David, 38100 Grenoble (FR)
(74) Mandataire: IP Trust
(86) Numéro de dépôt international: PCT/FR2018/050446
(87) Numéro de publication internationale: WO 2018/158529

(56) Documents cités:
- EP-A1- 2 151 852
- US-A1- 2010 087 049

## Description

### DOMAINE DE L'INVENTION

La présente invention concerne un substrat de croissance pour la formation de dispositifs optoélectroniques ainsi qu'un procédé de fabrication de ce substrat.

### ARRIERE PLAN TECHNOLOGIQUE DE L'INVENTION

Le document US20100072489 divulgue des structures semi-conductrices en matériau III-N comprenant chacune, sur un substrat de croissance, des couches électroluminescentes disposées entre une région de type n et une région de type p. Ces structures semi-conductrices peuvent être des diodes électroluminescentes (DELs). Le substrat de croissance comprend une pluralité d'îlots d'InGaN assemblée à un support de croissance par une couche d'assemblage. Le substrat de croissance est formé de telle sorte que chaque îlot d'InGaN est au moins partiellement relaxé. Ce document propose de former les couches électroluminescentes émettant une lumière bleue en InGaN comportant une proportion d'indium comprise entre 0,16 et 0,18 ; de former les couches électroluminescentes émettant une lumière cyan en InGaN comportant une proportion d'indium comprise entre 0,19 et 0,22 ; et de former les couches électroluminescentes émettant une lumière verte en InGaN comportant une proportion d'indium comprise entre 0,23 et 0,25. Des couches électroluminescentes émettant une lumière rouge pourraient requérir une proportion d'indium de l'ordre de 0,35.

Il est connu que la proportion d'indium qu'il est possible d'incorporer dans une couche d'InGaN au cours de sa croissance épitaxiale est limitée par son état de contrainte. Lorsque celui-ci est important, les atomes d'indium sont exclus de la maille d'InGaN pour former un alliage de composition différente et réduire l'énergie de contrainte du système. Idéalement, pour éviter ce phénomène de séparation de phase, on souhaiterait donc disposer d'un substrat de croissance comprenant des îlots d'InGaN présentant un paramètre de maille adapté pour recevoir des couches électroluminescentes relaxées. Ce paramètre de maille doit être adapté à la proportion d'InGaN déterminée pour que la couche électroluminescente émette une lumière de couleur choisie. Ainsi, pour former des DELs efficaces, il serait souhaitable de disposer d'un substrat de croissance comprenant des îlots d'InGaN présentant un paramètre de maille de l'ordre de 3,22 Â pour former des couches électroluminescentes émettant une couleur dans le bleue, ou présentant un paramètre de maille de l'ordre de 3,27 Å pour former des couches électroluminescentes émettant une couleur dans le vert, ou encore présentant un paramètre de maille de l'ordre de 3,31 Â pour former des couches électroluminescentes émettant une couleur dans le rouge.

Le document précité et les documents US2012241918, US2010087049, EP2151852 proposent des procédés permettant de former des ilots relaxés ou partiellement relaxés d'InGaN. Selon l'approche présentée dans ces documents, on forme tout d'abord sur un substrat donneur comprenant une couche superficielle de GaN, une couche contrainte d'InGaN destinée à former les îlots du substrat de croissance. Cette couche d'InGaN étant contrainte, il n'est généralement pas possible d'excéder une proportion d'indium d'nviron 8 à 10% sans détériorer la qualité de cette couche.

Cette couche contrainte d'InGaN est transférée sur un support de relaxation comportant une couche de fluage superficielle par collage et par amincissement et/ou fracture du substrat donneur. Puis on définit les îlots contraints dans la couche d'InGaN transférée. On traite thermiquement le support de relaxation et les îlots à une température supérieure à la température de transition visqueuse de la couche de fluage, ce qui conduit à la relaxation au moins partielle des îlots. Pour assister cette relaxation et éviter un phénomène de gauchissement des îlots au cours de la déformation plastique qui peut s'opérer, il est prévu de former une couche raidisseur sur les îlots, avant l'application du traitement thermique de relaxation. Comme cela est détaillé dans le document « Buckling suppression of SiGe islands on compilant substrates », Yin et al (2003), Journal of Applied Physics, 94(10), 6875-6882, le degré de relaxation d'un îlot obtenu après cette étape de traitement thermique est celui qui équilibre les contraintes présentes dans la couche raidisseur et dans l'îlot. La relaxation de la couche d'InGaN n'est donc généralement pas complète, sauf à former des îlots de très petites tailles moins sensibles au phénomène de gauchissement. La relaxation d'un îlot d'InGaN présentant une dimension de l'ordre du mm, en utilisant les techniques de l'état de la technique, permet d'atteindre un degré de relaxation compris entre 60 et 80%.

La combinaison d'une proportion d'indium limitée dans un îlot d'InGaN et d'une relaxation partielle de cet îlot conduit à limiter le paramètre de maille des îlots qu'il est possible d'obtenir sur un substrat de croissance, à moins de limiter très fortement la dimension de ces îlots. En conséquence, il n'est pas toujours possible de former des couches électroluminescentes émettant directement dans une longueur d'onde nécessitant un paramètre de maille relativement important, telle que dans le domaine du vert ou du rouge.

La présente invention vise à pallier tout ou partie des inconvénients précités.

Elle vise notamment à fournir un substrat présentant une couche de croissance ayant un paramètre de maille qui peut être librement choisi.

### BREVE DESCRIPTION DE L'INVENTION

En vue de la réalisation de l'un de ces buts, l'objet de l'invention propose un procédé de préparation d'une couche de semi-conducteur cristallin pour qu'elle présente un paramètre de maille déterminé, le procédé mettant en œuvre une séquence de relaxation comprenant :
- la formation d'une couche contrainte sur un substrat donneur de départ ;
- le transfert d'une partie au moins de la couche contrainte sur un support de relaxation comprenant une couche de fluage ;
- l'application d'un traitement thermique suffisant pour relaxer au moins en partie la couche contrainte et fournir une couche relaxée sur le support de relaxation ;
- le report de la couche relaxée sur un support de base pour former un second substrat donneur.

Selon l'invention, la séquence de relaxation est appliquée une première fois sur un premier substrat donneur de départ puis répétée, en prenant le second substrat donneur comme substrat donneur de départ, un nombre suffisant de fois pour que le paramètre de maille de la couche relaxée présente le paramètre de maille déterminé.

Selon d'autres caractéristiques avantageuses et non limitatives de l'invention, prises seules ou selon toute combinaison techniquement réalisable :
- le premier substrat donneur de départ comprend une couche superficielle de GaN ;
- la couche contrainte est une couche d'InGaN présentant une proportion d'indium suffisant pour être contrainte en compression lors de sa formation sur le substrat donneur de départ ;
- l'étape de transfert de la séquence de relaxation comprend le collage de la couche contrainte sur le support de relaxation comprenant une couche de fluage et l'élimination du substrat donneur de départ par amincissement et/ou fracture et/ou détachement laser ;
- l'élimination du substrat donneur de départ se réalise après l'étape de traitement thermique ;
- la séquence de relaxation comprend le traitement de la couche contrainte pour former des îlots avant l'étape de traitement thermique de relaxation ;
- la séquence de relaxation comprend une étape de formation d'une couche continue relaxée par dépôt coalescent sur les îlots après le report des îlots sur le support de base ;
- l'étape de report de la séquence de relaxation comprend le collage de la couche relaxée sur le support de base et l'élimination du support de relaxation et de la couche de fluage par amincissement et/ou fracture et/ou détachement laser ;
- le paramètre de maille déterminé est compris entre 3,22 Å et 3,31 Å.

### BREVE DESCRIPTION DES DESSINS

D'autres caractéristiques et avantages de l'invention ressortiront de la description détaillée de l'invention qui va suivre en référence aux figures annexées sur lesquels :
- la figure 1 représente une vue d'ensemble d'un procédé conforme à l'invention ;
- la figure 2 représente un exemple d'application d'une séquence de relaxation à un substrat donneur de départ ;

### DESCRIPTION DETAILLEE DE L'INVENTION

Par souci de simplification de la description à venir, les mêmes références sont utilisées pour des éléments identiques ou assurant la même fonction.

Un procédé conforme à l'invention vise à préparer une couche de semi-conducteur cristallin présentant un paramètre de maille déterminé ou cible. Ce paramètre de maille cible peut dépendre de l'application finale recherchée. À titre d'exemple et sans aucunement limiter le domaine d'application du procédé objet de la présente invention, on présente un procédé visant à préparer une couche d'InGaN cristallin apte à recevoir les couches électroluminescentes de DELs à base de nitrure émettant dans le domaine du bleu, du vert ou du rouge. Quel que soit l'état ou le degré de contrainte de cette couche, on vise qu'elle présente un paramètre de maille cible, à plus ou -0,5 % près, égal à 3,22Å, 3,27Å ou 3,31Å.

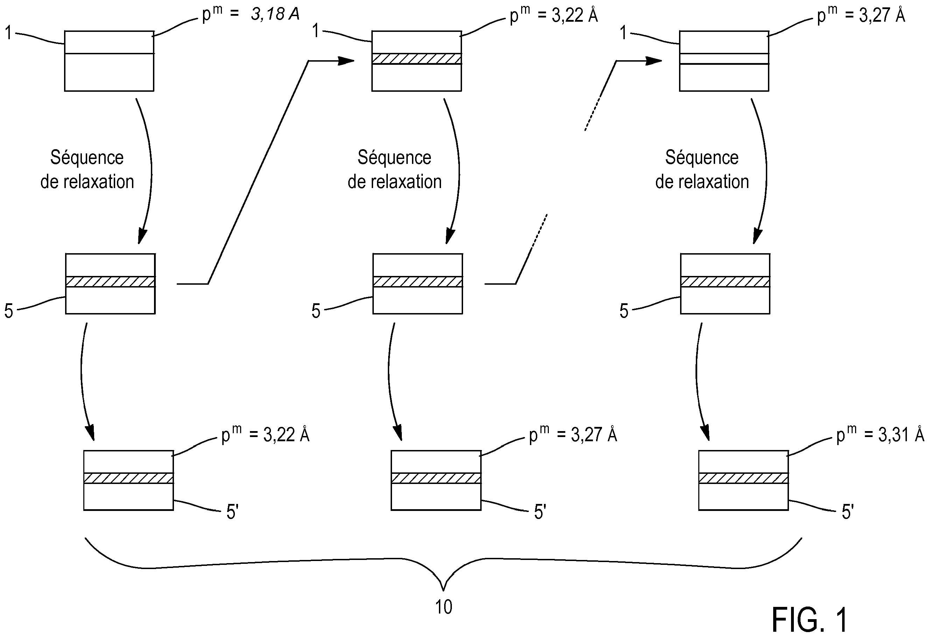

Comme cela est représenté schématiquement sur la figure 1, un procédé conforme à l'invention applique successivement au moins deux séquences de relaxation à une couche issue d'un premier substrat donneur de départ 1. Cette couche présente un premier paramètre de maille relativement éloignée du paramètre de maille cible, de l'ordre de 3,185 Â lorsque le substrat donneur de départ est constitué d'une couche de GaN disposé sur un support en saphir. À l'issue de l'application de la première séquence de relaxation, on dispose d'un second substrat donneur 5, comprenant une couche d'InGaN présentant un deuxième paramètre de maille, différent du premier et plus proche du paramètre de maille cible. On peut employer ce second substrat donneur 5 comme nouveau substrat donneur de départ 1 auquel on peut appliquer une deuxième séquence de relaxation. On dispose à l'issue de cette deuxième application, d'un nouveau second substrat donneur 5 comprenant une couche d'InGaN dont le paramètre de maille se rapproche encore du paramètre de maille cible. Ce cycle peut être renouvelé autant de fois que nécessaire pour obtenir un substrat donneur comprenant une couche de semi-conducteur cristallin présentant le paramètre de maille cible, par exemple égal ou proche de l'un de ceux qui viennent d'être listés dans le paragraphe précédent.

Avantageusement le procédé selon l'invention est appliqué simultanément à une pluralité de substrat donneur de départ. A l'issue de chaque itération de la séquence de relaxation, ou à l'issue de certaines de ces itérations, on peut prélever au moins un second substrat donneur parmi la pluralité de second substrat donneurs obtenue, si celui-ci comprend une couche dont le paramètre de maille est suffisamment proche, à 0,5% près, d'un des paramètres de maille cible. Les autres seconds substrats donneurs, non prélevés, pourront recevoir une nouvelle itération de la séquence de relaxation.

Ainsi, et comme cela sera détaillé dans le détail dans la suite de cet exposé, à l'issue de la première itération, on peut prélever un second substrat donneur 5 comprenant une couche d'InGaN présentant un paramètre de maille de l'ordre de 3,22 Å (à 0,5% près) ; prélever un second substrat donneur 5 à l'issue de la deuxième itération, ce second substrat donneur comprenant une couche d'InGaN dont le paramètre de maille est de l'ordre de 3,27 Å (à 0,5% près) ; et prélever un second substrat donneur 5 à l'issue de la troisième itération de la séquence de relaxation, ce second substrat donneur 5 comprenant une couche d'InGaN dont le paramètre de maille est de l'ordre de 3,31 Å (à 0,5% près).

On peut donc disposer à l'issue du procédé de l'invention d'une pluralité de seconds substrats donneurs 5 comprenant chacun une couche d'InGaN dont le paramètre de maille correspond à un des paramètres de maille cible. En conséquence, ces substrats donneurs peuvent chacun servir comme support de croissance pour la formation d'une couche électroluminescente émettant directement dans une longueur d'onde choisie.

Le procédé de l'invention pouvant être relativement complexe à mettre en œuvre, en particulier lorsque le nombre d'itérations de la séquence de relaxation est important, il est préférable de ne pas employer directement les seconds substrats donneurs 5 comme substrat de croissance de couches électroluminescentes, mais de les préserver comme substrats mères 5'. On peut prélever des couches de ces substrats mères 5' pour les reporter sur des supports secondaires, et les substrats secondaires ainsi formés pourront eux être utilisés comme substrat de croissance pour former les structures semi-conductrices électroluminescentes. Après chaque prélèvement, ou après un nombre déterminé de prélèvements, on peut réformer une épaisseur de la couche prélevée des substrats mères 5' pour la régénérer.

Sur une ligne de production de substrat de croissance pour des structures électroluminescentes, on pourra détenir une collection 10 de substrats mères 5' présentant chacun des caractéristiques différentes. Selon la nature de la structure semi-conductrice électroluminescente qui doit être fabriquée sur un substrat de croissance, on sélectionnera le substrat mère 5' comprenant une couche dont le paramètre de maille est le plus adapté à la fabrication de cette structure. A titre d'exemple, dans une ligne de production de substrats de croissance pour DELs, le procédé conforme à l'invention peut conduire à constituer une collection 10 de substrats mères 5', chaque substrat de la collection comprenant une couche dont le paramètre maille est adapté pour recevoir une DEL émettant directement une couleur déterminée. La collection 10 de substrats mères 5' peut ainsi comprendre :
- un premier substrat mère 5' comprenant une couche d'InGaN dont le paramètre de maille est de 3,22 Å (à 0,5% près) ;
- un deuxième substrat mère 5' comprenant une couche d'InGaN dont le paramètre de maille est de 3,27 Å (à 0,5% près) ;
- un troisième substrat mère 5' comprenant une couche d'InGaN dont le paramètre de maille est de 3,31 Å (à 0,5% près).

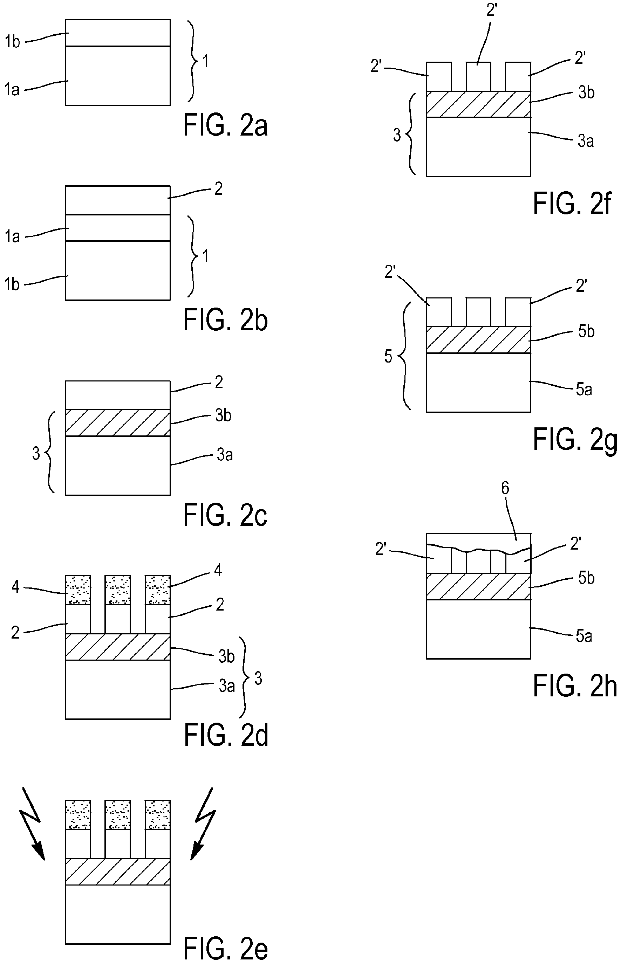

On expose maintenant plus en détail les étapes d'un procédé conforme à l'invention et visant à préparer une couche d'InGaN cristallin apte à recevoir des couches électroluminescentes de DELs à base de nitrure. Les figures 2a à 2h représentent ainsi un exemple d'application d'une séquence de relaxation à un premier substrat donneur de départ 1, et la figure 2a représente ce premier substrat donneur de départ 1. Il comprend un premier support de base la, sur lequel on a disposé une couche tampon de semi-conducteur 1b. Le premier support de base la peut correspondre à une plaquette circulaire, par exemple en silicium, en carbure de silicium ou en saphir, de dimensions normalisées de par exemple 2 pouces (50 mm), 4 pouces (100 mm), voire même de 200 mm de diamètre ou plus. Mais l'invention n'est nullement limitée à ces dimensions ou à cette forme. La couche tampon 1b peut-être une couche tampon de GaN formée par dépôt sur le premier support de base la. Elle présente une épaisseur suffisante, par exemple supérieure à 1 micron pour être suffisament relaxée et présenter un paramètre de maille sensiblement égal à 3,185 Å.

Dans une alternative non représentée, le premier substrat donneur de départ 1 peut être constitué d'un substrat massif, par exemple un substrat de GaN massif ou de SiC. Quelle que soit la nature ou la forme du premier substrat donneur de départ 1, celui-ci présente une surface exposée en un matériau semi-conducteur cristallin dont le paramètre de maille, désigné dans la suite de cet exposé par l'expression « paramètre de maille de départ », ne correspond pas aux paramètres de maille cible.

Dans une étape suivante de la séquence de relaxation, représentée sur la figure 2b, on forme une couche contrainte 2 sur le premier substrat donneur de départ 1. D'une manière générale, la nature de la couche 2, donc de sa contrainte compressive ou extensive, est choisie selon la valeur relative des paramètres de maille de départ et du paramètre de maille cible. Si le paramètre de maille de départ est inférieur aux paramètres de maille cible, on formera une couche contrainte 2 en compression. La relaxation de cette couche conduira à augmenter son paramètre de maille et donc à le rapprocher du paramètre de maille cible. Si au contraire, le paramètre de maille de départ est supérieur au paramètre de maille cible, on formera une couche contrainte 2 en tension. La relaxation de cette couche conduira à réduire son paramètre de maille et donc également à le rapprocher du paramètre de maille cible.

D'une manière générale également, la couche contrainte 2 présentera une épaisseur inférieure à son épaisseur critique de relaxation plastique, afin de préserver son état de contrainte et sa qualité cristalline.

Dans l'exemple représenté sur la figure 2, on forme une couche contrainte 2 d'InGaN en compression sur la couche de tampon 1b en GaN. On cherchera à former une couche contrainte 2 présentant une concentration d'indium maximale, sans toutefois excéder la concentration limite faisant apparaître une ségrégation de phase, ce qui pourrait détériorer la qualité cristalline de cette couche 2. Ainsi dans l'exemple représenté sur les figures 2, la couche contrainte pourra être formée d'une couche d'InGaN présentant une concentration d'indium comprise entre quelques % et 10%, préférentiellement égal à 8%, et une épaisseur de 200 nanomètres.

L'étape suivante de la séquence de relaxation consiste à transférer une partie au moins de la couche contrainte 2 sur un support de relaxation 3 comprenant une couche de fluage 3b en surface. À l'issue de cette étape de transfert, comme cela est montré sur la figure 2c, une partie au moins de la couche contrainte 2 est disposée en contact de la couche de fluage 3b du support de relaxation 3. La couche de fluage peut consister ou comprendre du BPSG.

De nombreuses méthodes de transfert de couche peuvent permettre de réaliser ce transfert, notamment les méthodes décrites dans les documents cités de l'état de la technique. À titre d'exemple, et pour assurer le caractère complet de la présente description, la méthode de transfert peut comprendre la succession d'étapes suivantes :
- l'application d'une première couche de fluage sur la face exposée de la couche contrainte ;
- l'implantation d'espèces légères (hydrogène et/ou hélium) à travers cette première couche de fluage pour former un plan fragile dans la couche contrainte 2 ou, préférablement, dans la couche tampon 1a ;
- la mise en contact de la première couche de fluage avec une seconde couche de fluage formée à la surface du support de relaxation 3, de manière à assembler le premier substrat de base 1 et le support de relaxation 3 l'un à l'autre. La couche contrainte 2 et la couche de fluage 3b sont intercalées entre ces deux éléments, la couche de fluage 3b étant constituée de l'assemblage de la première et de la seconde couche de fluage ;
- un apport d'énergie thermique et/ou mécanique pour fracturer l'ensemble au niveau du plan fragile formé par les espèces implantées.

Dans le cas où ce plan fragile a été formé dans la couche tampon 1a, le procédé de transfert conduit à reporter une partie de cette couche sur le support de relaxation 3. Cette partie de la couche tampon la peut être sélectivement enlevée par exemple par gravure sèche ou humide afin d'aboutir à la structure représentée sur la figure 2c.

Cette méthode de transfert est avantageuse en ce qu'elle permet de préserver la majeure partie du substrat donneur de départ 1, qui peut donc être réutilisé. Mais d'autres méthodes de transfert sont possibles, par exemple par assemblage du substrat de base 1 et du substrat de relaxation et par irradiation laser au travers du substrat de base 1a pour détacher celui-ci de la couche tampon 1b, ou encore par meulage et élimination physique de ce substrat de base 1a et/ou de la couche tampon 1b. L'invention n'est donc nullement limitée à une forme quelconque de transfert de la couche contrainte 2 sur le support de relaxation 3.

On note que l'élimination ou le retrait du substrat de base 1 et/ou de la couche tampon 1b n'est pas nécessairement réalisé avant d'appliquer l'étape suivante de traitement thermique de relaxation. On peut prévoir d'appliquer ce traitement thermique après l'étape d'assemblage et avant l'étape de retrait.

L'étape suivante de la séquence de relaxation comprend l'application d'un traitement thermique à la structure de la figure 2c comprenant le substrat de relaxation et la couche contrainte 2 pour relaxer au moins en partie cette couche 2 et fournir une couche au moins partiellement relaxée 2'. Par soucis de simplification, on désignera, dans la suite de la description, par l'expression « couche relaxée 2 » cette couche au moins partiellement relaxée. Ce traitement thermique dit de relaxation expose la couche de fluage 3b à une température supérieure à sa température de transition vitreuse. La viscosité de la couche du fluage est alors suffisante pour permettre, au moins partiellement, à la couche contrainte 2 de se relaxer plastiquement, par extension latérale. Le traitement thermique de relaxation peut à titre d'exemple comprendre l'exposition de la structure à une température de 300°C à 1000°C pendant quelques minutes à quelques heures heures dans une atmosphère neutre, selon la nature de la couche de fluage. Lorsque celle-ci comprend du BPSG, le traitement thermique peut comprendre l'exposition de la structure à 900°C pendant 1 heure.

Comme on l'a décrit précédemment, cette extension latérale peut provoquer un gauchissement de la couche contrainte 2 au cours de sa relaxation. Afin de limiter cela, il est préférable de former sur la couche contrainte 2, avant l'application du traitement thermique de relaxation, une couche raidisseur 4. De plus, toujours dans le but de faciliter la relaxation au cours du traitement thermique de relaxation, il est également avantageux de définir dans la couche contrainte 2 des îlots de matériaux, par l'intermédiaire de tranchées s'étendant au moins à travers la couche 2 et, optionnellement, dans la couche de fluage 3b.

La figure 2d représente ainsi la structure avantageusement préparée avant l'application du traitement thermique de relaxation. Ce traitement thermique de relaxation est représenté symboliquement sur la figure 2e. Il peut être répété plusieurs fois afin de relaxer plus pleinement la couche 2 ou les îlots de la couche 2. On peut prévoir d'amincir entre deux applications d'un traitement thermique, voire même éliminer complètement, la couche raidisseur 4. Quelle que soit la forme du traitement thermique de relaxation, à l'issue de son application on peut procéder à l'enlèvement de la couche raidisseurs 4. On dispose alors, et comme cela est représenté sur la figure 2f d'une couche au moins partiellement relaxée 2' d'InGaN. Cette couche peut être constituée d'une pluralité d'îlots, si de tels îlots ont été formés avant l'application du traitement thermique de relaxation, comme cela a été expliqué auparavant. En tout état de cause, la couche relaxée 2' est disposée sur la couche de fluage 3b du support de relaxation 3.

Dans une étape suivante de la séquence de relaxation, on reporte la couche relaxée 2' d'InGaN sur un support de base 5a. Ce report peut comprendre l'assemblage de la couche relaxée 2' au support de base 5a, éventuellement en intercalant une couche d'assemblage 5b, et le retrait du support de relaxation 3, y compris la couche de fluage 3b. Celui-ci peut être éliminé mécaniquement, par démontage par irradiation laser si celui-ci est transparent, ou par toute autre méthode. La couche de fluage 3b peut être éliminée par gravure chimique. À l'issue de cette étape, on dispose de la couche relaxée d'InGaN 2', éventuellement disposée sur une couche d'assemblage 5b, elle-même disposée sur le support de base 5a. Cette structure forme un second substrat donneur 5. La couche relaxée 2' peut être constituée d'un ensemble d'îlots. La couche relaxée d'InGaN 2' présente un paramètre de maille de l'ordre de 3,22 A. Ce paramètre de maille peut être suffisant pour y former des couches photoluminescentes émettant dans le domaine du bleu, mais insuffisante pour y former des couches photoluminescentes émettant dans le domaine du rouge et du vert. Ils restent inférieurs aux paramètres de maille cibles qui ont été prédéfinis pour ces deux couleurs d'émission. Pour corriger cela, et comme cela est apparent sur la figure 1, on répète l'application de la séquence de relaxation qui vient d'être décrite, en prenant le second substrat donneur 5 comme nouveau substrat donneur de départ.

Dans le cas où la couche relaxée 2' est constituée d'îlots, comme cela est recommandé et représenté sur les figures 2d à 2g, on peut prévoir avant d'appliquer à nouveau la séquence de relaxation, de croître sur ces îlots une couche de recouvrement 6, composée d'InGaN et présentant par exemple la même teneur en indium que celle formant les îlots. Cette couche de recouvrement vise à refermer les tranchées séparant les îlots et donc à former, à la surface du second substrat donneur 5 une couche continue. Cette configuration est représentée sur la figure 2h. Elle peut être obtenue par surcroissance latérale par épitaxie (« epitaxial lateral overgrowth » selon l'expression anglo-saxonne consacrée).

Lorsqu'on applique à nouveau la séquence de relaxation en prenant le second substrat donneur 5 comme substrat de départ, la couche tampon 1b du substrat de départ est alors constituée par la couche relaxée 2' et éventuellement de la couche de recouvrement 6 si celle-ci est présente. Le support de départ la est constitué du support de base 5a et de la couche d'assemblage 5b.

Dans la deuxième itération de la séquence de relaxation, et dans les itérations suivantes, l'étape de formation de la couche contrainte 2 comprend la formation d'une couche d'InGaN présentant une concentration d'indium supérieure à celle de la couche contrainte de l'itération précédente. En effet, le paramètre de maille de la couche tampon 1b dans la nouvelle itération est plus grand que le paramètre de maille de la couche tampon de l'itération précédente. Cela permet donc d'incorporer une plus grande proportion indium dans la couche contrainte 2 sans entrainer de séparation de phase. À titre d'exemple, la couche d'InGaN peut présenter une concentration d'indium comprise entre 10% et 20% , dans la seconde itération de l'exemple décrit.

Dans le cas où l'on n'a pas formé de couche de recouvrement 6 sur le second substrat donneur 5 et que, en conséquence, la couche tampon 1b est constituée d'îlots, on peut prévoir que l'étape de formation de la nouvelle couche contrainte 2, dans la nouvelle itération de la séquence de relaxation, conduise à recouvrir ces îlots et à former une couche contrainte continue 2.

En renouvelant complètement l'application de la séquence de relaxation telle qu'elle a été décrite précédemment, on aboutit à l'issue du deuxième cycle à un second substrat donneur 5 présentant une couche relaxée 2' d'InGaN, et éventuellement une couche de recouvrement 6, présentant un paramètre de maille de l'ordre de 3,27%. Ce second substrat issu la seconde itération présente donc une couche relaxée en InGaN dont le paramètre de maille est adapté à la fabrication d'une DEL émettant dans le domaine du vert. Elle peut donc être exploitée à cet effet ou être préservé comme substrat mère 5', comme cela a été décrit précédemment.

Pour obtenir une couche présentant un paramètre de maille adapté la fabrication d'une DEL rouge, on peut reproduire un nouveau cycle ou autant de cycle que nécessaires. À chaque nouveau cycle, la proportion d'InGaN lors de la formation de la couche contrainte 2 de la séquence de relaxation peut être augmentée. Et à l'issue de chaque nouveau cycle, on dispose d'un second substrat donneur 5 dont le paramètre de maille a été augmenté. D'une manière plus générale, à l'issue de chaque nouveau cycle, on dispose d'une couche de semi-conducteur cristallin au moins partiellement relaxée dont le paramètre de maille se rapproche du paramètre de maille cible.

Bien entendu l'invention n'est pas limitée aux modes de mise en œuvre décrits et on peut y apporter des variantes de réalisation sans sortir du cadre de l'invention tel que défini par les revendications.

En particulier, bien qu'ici on ait pris l'exemple d'une couche de semi-conducteur cristallin d'InGaN, les principes de l'invention sont applicables à tout autre matériau dont on souhaite adapter le paramètre de maille.

Enfin, bien qu'ici on ait pris l'exemple de la réalisation de DELs, l'invention peut trouver des applications pour la réalisation d'autres types de dispositifs dans le domaine de l'optoélectronique ou de l'électronique.

## Revendications

1. Procédé de préparation d'une couche de semi-conducteur cristallin (2') pour qu'elle présente un paramètre de maille déterminé, le procédé mettant en œuvre une séquence de relaxation comprenant :
- la formation d'une couche contrainte (2) sur un substrat donneur de départ (1) ;
- le transfert d'une partie au moins de la couche contrainte (2) sur un support de relaxation (3) comprenant une couche de fluage (3b) ;
- l'application d'un traitement thermique suffisant pour relaxer au moins en partie la couche contrainte (2) et fournir une couche relaxée (2') sur le support de relaxation (3);
- le report de la couche relaxée (2') sur un support de base (5a) pour former un second substrat donneur (5) ;
le procédé étant **caractérisé en ce que** ladite séquence de relaxation est appliquée une première fois sur un premier substrat donneur de départ (1) puis répétée, en prenant le second substrat donneur (5) comme substrat donneur de départ, un nombre suffisant de fois pour que le paramètre de maille de la couche relaxée (2') présente le paramètre de maille déterminé.

2. Procédé selon la revendication précédente dans lequel le premier substrat donneur de départ (1) comprend une couche superficielle (1a) de GaN.

3. Procédé selon l'une des revendications précédentes dans lequel la couche contrainte (2) est une couche d'InGaN présentant une proportion d'indium suffisant pour être contrainte en compression lors de sa formation sur le substrat donneur de départ (1).

4. Procédé selon l'une des revendications précédentes dans lequel l'étape de transfert de la séquence de relaxation comprend le collage de la couche contrainte (2) sur le support de relaxation (3) comprenant une couche de fluage (3b) et l'élimination du substrat donneur de départ (1) par amincissement et/ou fracture et/ou détachement laser.

5. Procédé selon la revendication précédente dans lequel l'élimination du substrat donneur de départ (1) se réalise après l'étape de traitement thermique.

6. Procédé selon l'une des revendications précédentes dans lequel la séquence de relaxation comprend le traitement de la couche contrainte (2) pour former des îlots avant l'étape de traitement thermique de relaxation.

7. Procédé selon la revendication précédente dans lequel la séquence de relaxation comprend une étape de formation d'une couche continue relaxée (6) par dépôt coalescent sur les îlots (2') après le report des îlots (2') sur le support de base (5a).

8. Procédé selon l'une des revendications précédentes dans lequel l'étape de report de la séquence de relaxation comprend le collage de la couche relaxée (2') sur le support de base (5a) et l'élimination du support de relaxation (3a) et de la couche de fluage (3b) par amincissement et/ou fracture et/ou détachement laser.

9. Procédé selon l'une des revendications précédentes dans lequel le paramètre de maille déterminé est compris entre 3,22 Å et 3,31 Å.

## Patentansprüche

1. Verfahren zum Herstellen einer kristallinen Halbleiterschicht (2') mit einem bestimmten Gitterparameter, wobei das Verfahren eine Entsprannungssequenz implementiert, Folgendes umfassend:
- Bilden einer Spannungsschicht (2) auf einem Ausgangs-Donor-Substrat (1);
- Übertragen mindestens eines Teils der Spannungsschicht (2) auf einen Entspannungsträger (3), umfassend eine Kriechschicht (3b);
- Anwenden einer Wärmebehandlung, die ausreicht, um die Spannungsschicht (2) zumindest teilweise zu entspannen und eine entspannte Schicht (2') auf dem Entspannungsträger (3) bereitzustellen;
- Überführen der entspannten Schicht (2') auf einen Grundträger (5a), um ein zweites Donor-Substrat (5) zu bilden;
wobei das Verfahren **dadurch gekennzeichnet ist, dass** die Entspannungssequenz ein erstes Mal auf ein erstes Ausgangs-Donor-Substrat (1) angewendet und dann, ausgehend von dem zweiten Donor-Substrat (5) als Ausgangs-Donor-Substrat, eine ausreichende Anzahl von Malen wiederholt wird, damit der Gitterparameter der entspannten Schicht (2') den bestimmten Gitterparameter aufweist.

2. Verfahren nach dem vorhergehenden Anspruch, wobei das erste Ausgangs-Donor-Substrat (1) eine Oberflächenschicht (a) aus GaN aufweist.

3. Verfahren nach einem der vorhergehenden Ansprüche, wobei die Spannungsschicht (2) eine InGaN-Schicht ist, die einen ausreichenden Anteil an Indium aufweist, um während ihrer Bildung auf dem Ausgangs-Donor-Substrat (1) unter Druck beansprucht zu werden.

4. Verfahren nach einem der vorhergehenden Ansprüche, wobei der Schritt des Übertragens der Entspannungssequenz das Verbinden der Spannungsschicht (2) mit dem eine Kriechschicht (3b) umfassenden Entspannungsträger (3) und das Entfernen des Ausgangs-Donor-Substrats (1) durch Ausdünnen und/oder Brechen und/oder Laserablösung umfasst.

5. Verfahren nach dem vorhergehenden Anspruch, wobei die Entfernung des Ausgangs-Donor-Substrats (1) nach dem Wärmebehandlungsschritt durchgeführt wird.

6. Verfahren nach einem der vorhergehenden Ansprüche, wobei die Entspannungssequenz die Behandlung der Spannungsschicht (2) zur Bildung von Inseln vor dem Schritt der Entspannungswärmebehandlung umfasst.

7. Verfahren nach dem vorhergehenden Anspruch, wobei die Entspannungssequenz einen Schritt der Bildung einer kontinuierlichen entspannten Schicht (6) durch koaleszente Abscheidung auf den Inseln (2') nach der Überführung der Inseln (2') auf den Basisträger (5a) umfasst.

8. Verfahren nach einem der vorhergehenden Ansprüche, wobei der Schritt des Überführens der Entspannungssequenz das Verbinden der entspannten Schicht (2') mit dem Basisträger (5a) und das Entfernen des Entspannungsträgers (3a) und der Kriechschicht (3b) durch Ausdünnen und/oder Brechen und/oder Laserablösung umfasst.

9. Verfahren nach einem der vorhergehenden Ansprüche, wobei der bestimmte Gitterparameter zwischen 3,22 Å und 3,31 Å liegt.

## Claims

1. Method for preparing a crystalline semiconductor layer (2') such that it has a predetermined mesh parameter, the method implementing a relaxation sequence comprising:
- forming a strained layer (2) on a starting donor substrate (1);
- transferring at least part of the strained layer (2) onto a relaxation support (3) comprising a creep layer (3b);
- applying a heat treatment that is sufficient for at least partially relaxing the strained layer (2) and providing a relaxed layer (2') on the relaxation support (3);
- transferring the relaxed layer (2') onto a base support (5a) to form a second donor substrate (5);
the method being **characterized in that** said relaxation sequence is applied a first time to a first starting donor substrate (1) and then repeated, taking the second donor substrate (5) as the starting donor substrate, a sufficient number of times such that the mesh parameter of the relaxed layer (2') has the predetermined mesh parameter.

2. Method according to the preceding claim, wherein the first starting donor substrate (1) comprises a surface layer (1a) of GaN.

3. Method according to either of the preceding claims, wherein the strained layer (2) is a layer of InGaN having a sufficient proportion of indium to be compressively strained during its formation on the starting donor substrate (1).

4. Method according to any of the preceding claims, wherein the step of transferring the relaxation sequence comprises bonding the strained layer (2) to the relaxation support (3) comprising a creep layer (3b) and removing the starting donor substrate (1) by thinning and/or fracture and/or laser detachment.

5. Method according to the preceding claim, wherein the starting donor substrate (1) is removed after the heat treatment step.

6. Method according to any of the preceding claims, wherein the relaxation sequence comprises treating the strained layer (2) to form islands before the relaxation heat treatment step.

7. Method according to the preceding claim, wherein the relaxation sequence comprises a step of forming a relaxed continuous layer (6) by coalescing deposition on the islands (2') after the transfer of the islands (2') onto the base support (5a).

8. Method according to any of the preceding claims, wherein the step of transferring the relaxation sequence comprises bonding the relaxed layer (2') to the base support (5a) and removing the relaxation support (3a) and the creep layer (3b) by thinning and/or fracture and/or laser detachment.

9. Method according to any of the preceding claims, wherein the predetermined mesh parameter is between 3.22 Å and 3.31 Å.
